# EUROPEAN PATENT APPLICATION

(11) **EP 1 619 725 A2**
(43) Date of publication of application: **25.01.2006**
(21) Application number: 05013531.8
(22) Date of filing: 23.06.2005
(51) Int. Cl.: H01L 29/868, H01L 27/12

(54) **Thin film semiconductor device and method of manufacturing the same, electro-optical device, and electronic apparatus**

(30) Priority: 23.07.2004 JP 2004215333; 12.04.2005 JP 2005114230
(71) Applicant: SEIKO EPSON CORPORATION, Shinjuku-ku, Tokyo 163-0811 (JP)
(72) Inventor: Eguchi, Tsukasa, Suwa-shi Nagano-ken 392-8502 (JP); Matsumoto, Tomotaka, Suwa-shi Nagano-ken 392-8502 (JP); Fujita, Shin, Suwa-shi Nagano-ken 392-8502 (JP)
(74) Representative: HOFFMANN EITLE

(57) **Abstract**

A thin film semiconductor device includes a substrate and a semiconductor film formed on the substrate. The thin film semiconductor device further includes a protective circuit element having a PIN diode having the semiconductor film, and a floating electrode disposed opposite to an I layer of the PIN diode with an insulating film disposed therebetween.

## Description

### BACKGROUND OF THE INVENTION

### 1. Technical Field

The present invention relates to a thin film semiconductor device, to a method of manufacturing the same, to an electro-optical device, and to an electronic apparatus.

### 2. Related Art

Generally, semiconductor integrated circuit devices or active-matrix-type electro-optical devices include a protective circuit for protecting internal circuits from static electricity. For example, the electro-optical devices have a protective circuit disposed between internal circuits, such as a pixel switching element and a driving circuit, and a pad for drawing an electrode. The semiconductor integrated circuit devices use a diode as a protective circuit. The electro-optical devices use a diode-connected thin film transistor (hereinafter, referred to as a TFT). This is because in the electro-optical devices, it is difficult to form a TFT using a thin film semiconductor layer formed on an insulating substrate, and to form a PN junction of a diode in the thin film semiconductor layer (for example, Japanese Unexamined Patent Application Publication No. 6-51346).

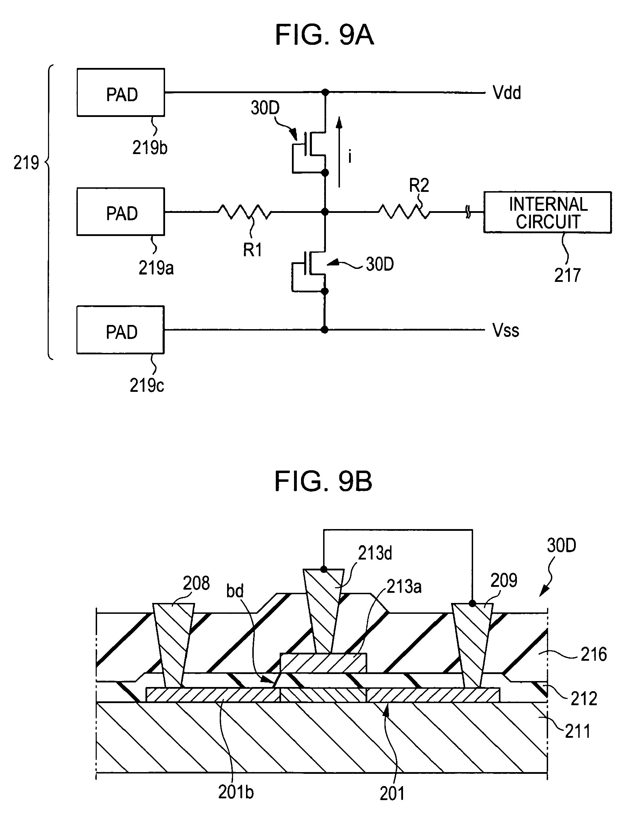

FIG. 9A is a diagram showing the structure of a protective circuit using a diode-connected TFT, and FIG. 9B is a cross-sectional view schematically showing the diode-connected TFT. As shown in FIG. 9A, two resistive elements R1 and R2 are interposed between a connection pad 219 and an internal circuit 217. Two diode-connected TFTs 30D are disposed along a path that connects connection pads 219b (Vdd) and 219c (Vss) between the resistive elements R1 and R2. The sectional structure shown in FIG. 9B will be described below. The diode-connected TFT 30D includes a semiconductor film 201 formed on a substrate 211, a gate electrode 213a disposed opposite to the semiconductor film 201 with a gate insulating film 212 interposed therebetween, and a source electrode 208 and a drain electrode 209, which are connected to the semiconductor film 201 through contact holes formed in the insulating films 212 and 216. Further, the drain electrode 209 and a connection electrode 213d connected to the gate electrode 213a through a contact hole formed in the insulating film 216 are short-circuited, thereby forming a TFT having the diode-connected structure.

In this structure, for example, if a positive surge voltage, such as static electricity, is input from the connection pad 219a, a current i flows through the diode-connected TFT 30D, thereby preventing an excessive current from flowing through the internal circuit 217.

If the diode-connected TFT is used in the protective circuit, as in the protective circuit constructed above, there is an advantage in that the protective circuit can be formed using the same process as the TFTs constituting an internal circuit. In this structure, however, as in FIG. 9B, if a surge voltage exceeding the withstand voltage of the diode-connected TFT 30D is input, the electrical charge penetrates the gate insulating film 212, which is a thin insulating film, of the diode-connected TFT 30D, thus forming a short-circuit path bd. Upon being short circuited, the gate electrode 213a is electrically connected to the source region 201b of the semiconductor film 201 through the short-circuit path bd. As a result, the drain electrode 209 and the source electrode 208 connected to the gate electrode 213a become conductive. Then, the connection pads 219 shown in FIG. 9A and other connection pads 219b to 219c are electrically connected to each other, and the connection pad 219a cannot operate in a normal manner. This leads to problems in the semiconductor device.

### SUMMARY

An advantage of the invention is that it provides a thin film semiconductor device having a protective circuit element for effectively protecting an internal circuit from a surge voltage with excellent reliability, whereby problems do not occur in the circuit structure even if the protective circuit is broken due to an excessive voltage, and a method of manufacturing the same.

According to a first aspect of the invention, there is provided a thin film semiconductor device including a substrate, a semiconductor film formed on the substrate, and a protective circuit element that includes a PIN diode having the semiconductor film and a floating electrode disposed opposite to an I layer of the PIN diode with an insulating film interposed therebetween.

The PIN diode is a diode having a semiconductor film in which a P layer (a P-type semiconductor layer), an I layer (an intrinsic semiconductor layer or a semiconductor layer into which an impurity of a low concentration is implanted), and an N layer (a N-type semiconductor layer) are defined, as well known. Furthermore, the floating electrode is an electrode, which is not connected to electrically controlled conductive films or a constituting member of a semiconductor layer, but is in an electrically 'floated' state.

The protective circuit element provided in the thin film semiconductor device of the invention includes the PIN diode and the floating electrode disposed opposite to the I layer. Therefore, in a case in which the excessive current flows through the protective circuit element and the gate insulating film is broken and in an electrically conductive state, the P layer (or the N layer) of the PIN diode and the floating electrode are adapted to be short-circuited from each other. Since the floating electrode is not connected to the electrically controlled conductive layers or the semiconductor layer, it is possible to secure the insulation of the PIN diode even after the protective circuit element is broken. Therefore, if a protective circuit is constructed using the protective circuit element, an electrostatic protective circuit that can bypass the surge voltage due to static electricity, etc., can be constructed. It is also possible to provide a thin film semiconductor device that can normally operate even after the surge voltage that can break the protective circuit element is input.

In addition, between a case in which the floating electrode is provided and a case in which the floating electrode is not provided, there is the significant difference in the protection performance of a backward direction. In a state where the floating electrode is not provided, a semiconductor layer having an excellent quality does not have a protection function up to the voltage corresponding to the breakdown voltage. However, a little leakage current is generated due to the floating electrode. Therefore, the thin film semiconductor device can have a protection function even against the surge voltage of a backward direction, which may have a bad influence on a TFT device, if it is a little.

According to a second aspect of the invention, there is provided a thin film semiconductor device including a main circuit unit having a semiconductor element, a terminal unit extending from the main circuit unit, and a protective circuit unit disposed between the main circuit unit and the terminal unit, all of which are formed on a substrate. Further, the protective circuit unit can a protective circuit element that includes a PIN diode having the semiconductor film, and a floating electrode disposed opposite to an I layer of the PIN diode with an insulating film interposed therebetween.

The protective circuit element is adapted to secure the insulation of a PIN diode itself even when it is broken due to excessive current. For this reason, if the protective circuit unit having the protective circuit element is provided, the circuit structure that connects a terminal unit and a main circuit unit is not changed although the protective circuit element is broken due to the excessive surge current input from the terminal unit, unlike the protective circuit element made of the diode-connected TFT of the related art. Therefore, the invention can provide a thin film semiconductor device, which has high the reliability and a long life span and can normally operate even after the surge voltage that can break a protective circuit element is input.

In the thin film semiconductor device, it is preferable that the semiconductor film constituting the PIN diode and a semiconductor film constituting the semiconductor element of the main circuit unit be a semiconductor film formed in the same layer on the substrate. According to this construction, the semiconductor element of the main circuit unit and the PIN diode can be formed in the same process. It is thus possible to improve the reliability of a thin film semiconductor device without changing a manufacturing process.

In the thin film semiconductor device, it is preferable that the semiconductor element provided in the main circuit unit be a thin film transistor, and a conductive film constituting the floating electrode and a conductive film constituting a gate electrode of the thin film transistor be formed in the same layer on the substrate. According to the structure, there is an advantage in that the thin film transistor of the main circuit unit and the protective circuit element can be formed in the same process.

In the thin film semiconductor device, it is preferable that the floating electrode and the I layer of the PIN diode be formed approximately at the same location in plan view. According to this structure, the I layer of the PIN diode can be formed in a self-aligned manner by introducing an impurity into a semiconductor film using a floating electrode as a mask. Thus, a protective circuit element can be fabricated by means of a simple process. Further, if the thin film transistor is provided in a main circuit unit, an I layer of a PIN diode can be simultaneously formed at the same time through a process of forming a channel region in a self-aligned manner using a gate electrode of the thin film transistor as a mask. This results in a thin film semiconductor device with excellent manufacturing efficiency.

In the thin film semiconductor device, it is preferable that a PIN diode have a low concentration impurity region, which has an impurity concentration lower than that of a P layer or a N layer, between the P layer and the I layer or the N layer and the I layer. In the same manner as a general semiconductor device, a thin film transistor provided in a thin film semiconductor device frequently adopts the LDD (Lightly Doped Drain) structure in order to prevent degradation of electrical characteristics due to hot carriers. Further, if the PIN diode according to this structure is adopted, a manufacturing process can be standardized in the case in which a protective circuit element is formed at the same time as the thin film transistor of the LDD structure. Moreover, the withstand voltage of the PIN diode can further increase even in terms of electrical characteristics, and the protective circuit element with high reliability can be provided.

In the thin film semiconductor device, it is preferable that the low concentration impurity region be formed in a region where it overlaps a floating electrode in plan view. If this structure is adopted, although the thin film transistor of the main circuit unit has the GOLDD (gate overlapped lightly doped drain) structure, the manufacturing process can be standardized and the withstand voltage of a PIN diode can further increase.

In the thin film semiconductor device, it is preferable that the floating electrode disposed opposite to the I layer of the PIN diode with the insulating film interposed therebetween have a portion in which the floating electrode overlap some of the P layer or the N layer of the PIN diode in plan view.

In this case, it is not necessary to stick to a method of forming a channel region, in which an impurity is introduced into a semiconductor film using a floating electrode, which is disposed to partially overlap the semiconductor film in plan view, as a mask, so called in a self-aligned manner. Therefore, an impurity can be introduced into a semiconductor film using a photoresist formed on a general insulating film as a mask. In this case, it is possible to enhance the degree of freedom of the manufacturing process. That is, the main circuit and the protective circuit element can be fabricated by means of a common manufacturing process, and can also be fabricated by a separate process. As such, although a manufacturing process is different according to the situation, the same electrical characteristics of the protective circuit element as that described above can be obtained.

In the thin film semiconductor device, it is preferable that the protective circuit element be directly connected to the terminal unit.

As shown in FIG. 9, in a protective circuit in which the diode-connected TFT according to the prior art is used in a protective circuit element, a resistive element R1 is disposed between a connection pad 219a and a diode-connected TFT 30D. In this case, the resistive element R1 is an element usually having a N-type or a P-type semiconductor layer, but has a function of prohibiting the abrupt voltage rise due to the surge voltage inputted from a connection pad 219a, thereby protecting a diode-connected TFT 30D. Further, even when the diode-connected TFT 30D is broken and thus becomes a conductive state, a power supply line Vdd or Vss serves to directly prevent a short circuit with a connection pad 219a. In the thin film semiconductor device, the pad 219a becomes rarely short with Vdd or Vss of the power supply line even when the protective circuit element is broken, as described above. It is thus possible to secure the electrical connection between the terminal unit and the main circuit unit. On the contrary, if the resistive element is disposed between the protective circuit element and the terminal unit, it can be broken when the input surge voltage is excessively high. Therefore, since the terminal unit and the internal circuit are disconnected, the thin film semiconductor device does not normally operate. Therefore, if the structure in which the protective circuit element and the terminal unit are directly connected is adopted, the thin film semiconductor device can guarantee the normal operation of the main circuit unit even if the voltage that can break the protective circuit unit is inputted.

According to a third aspect of the invention, there is provided a method of manufacturing a thin film semiconductor device having a substrate and a semiconductor film formed on the substrate, the method includes forming a protective circuit element. The forming of a protective circuit element includes forming a semiconductor film on a substrate, forming an insulating film on the semiconductor film, forming a conductive film on the insulating film, forming a floating electrode that overlaps the semiconductor film in plan view, and forming a P layer, an N layer, and an I layer in the semiconductor film by introducing an impurity into the semiconductor film using the floating electrode as a mask and forming a PIN diode.

According to this aspect, each layer of a PIN diode can be formed by introducing an impurity into a semiconductor film using the floating electrode as a mask. It is therefore possible to form a protective circuit element with excellent reliability in an efficient manner, and thus to manufacture a thin film semiconductor device with excellent reliability with easy and efficiency.

According to a fourth aspect of the invention, there is provided a method of manufacturing a thin film semiconductor device including a main circuit unit having a semiconductor element, a terminal unit extending from the main circuit unit, and a protective circuit unit disposed between the main circuit unit and the terminal unit, all of which are formed on a substrate, the method includes forming the protective circuit unit which includes forming of a protective circuit element.

In this case, the thin film semiconductor device includes an external connection terminal. It is possible to fabricate a thin film semiconductor device in a convenient and efficient manner, which can advantageously protect a main circuit unit from the surge voltage input from a terminal unit.

According to this aspect, it is preferable that the main circuit unit include a thin film transistor having a semiconductor film, and a gate electrode opposite to the semiconductor film with an insulating film interposed therebetween. It is preferable that the semiconductor film constituting the thin film transistor and a semiconductor film constituting the protective circuit element be formed in the same process, and the gate electrode constituting the thin film transistor and the floating electrode constituting the protective circuit element be formed in the same process. Further, it is preferable that a source or drain of the thin film transistor, and the P layer or the N layer of the PIN diode is preferably formed in the same impurity introducing process.

In this case, a thin film transistor constituting a main circuit unit and a protective circuit element can be fabricated in the same process. It is thus possible to fabricate a thin film semiconductor device with excellent reliability without changing a manufacturing process.

Further, it is preferable that in the impurity implant process, a low concentration impurity region having a lower impurity concentration than that of a neighboring impurity introduction region be formed in the semiconductor film of the thin film transistor and the semiconductor film of the protective circuit element. Therefore, a thin film transistor having the LDD structure, and a protective circuit element including a structure of the withstand voltage higher than that of the above-mentioned PIN diode can be formed in the same process.

According to a fifth aspect of the invention, there is provided an electro-optical device having the above-mentioned thin film semiconductor device. The thin film semiconductor device can be used as a TFT array substrate of an active-matrix-type electro-optical device. In this TFT array substrate, a TFT is used as a switching element of a pixel, which constitutes an image display area. An inverter using a TFT is also formed in a driving circuit disposed in a frame region. Further, a terminal unit serving as an external connection terminal is disposed. If the above-mentioned structure is applied to such a TFT array substrate, the switching element or the driving circuit of the image display area constituting an internal circuit can be advantageously protected by means of the protective circuit unit. It is thus possible to construct electro-optical devices having excellent reliability and a long life span.

According to a sixth aspect of the invention, there is provided an electronic apparatus including the above-mentioned electro-optical device. In this case, the electronic apparatus includes a protective circuit, which can advantageously protect an internal circuit from the excessive voltage such as the surge voltage. It is therefore possible to construct electronic apparatuses having a display unit of excellent reliability and a long life span.

### BRIEF DESCRIPTION OF THE DRAWINGS

The invention will be described with reference to the accompanying drawings, wherein like numbers reference like elements, and wherein:
FIG. 1 is a diagram showing the structure of a protective circuit of a thin film semiconductor device according to a first embodiment of the invention;
FIG. 2 is a plan view and a cross-sectional view of a protective circuit element according to the first embodiment of the invention;
FIG. 3 is a diagram showing a liquid crystal display device of the invention;
FIG. 4 is a circuit diagram of the liquid crystal display device and a cross-sectional view of a thin film transistor (TFT) according to the invention;
FIG. 5 is a schematic cross-sectional view of a protective circuit element according to a second embodiment of the invention;
FIG. 6 is a schematic cross-sectional view of a protective circuit element according to a third embodiment of the invention;
FIG. 7 is a schematic cross-sectional view of a protective circuit element according to a fourth embodiment of the invention;
FIG. 8 is a perspective view illustrating an example of an electronic apparatus;
FIGS. 9A and 9B are diagrams showing a protective circuit of a thin film semiconductor device in the prior art;
FIG. 10 is a diagram illustrating the results of comparing TLP characteristics of a PIN diode depending upon whether a floating electrode according the invention exists or not;
FIG. 11 is a diagram showing a protective circuit of another thin film semiconductor device according to the invention; and
FIG. 12 is a graph showing the results of comparing electrical characteristics of a PIN diode depending upon whether a low concentration region according the invention exists or not.

### DESCRIPTION OF THE EMBODIMENTS

### First Embodiment

Hereinafter, preferred embodiments of the invention will be described with reference to the accompanying drawings. In the present embodiment, the basic configuration of a thin film semiconductor device according to the invention, and an electro-optical device having the thin film semiconductor device will be exemplified.

### Thin Film Semiconductor Device

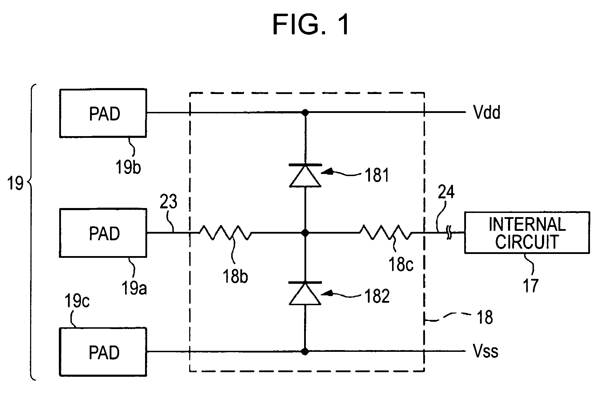

FIG. 1 is a diagram showing the structure of a thin film semiconductor device according to a first embodiment of the invention. Referring to FIG. 1, the thin film semiconductor device according to the present embodiment includes an internal circuit (a main circuit unit) 17, a protective circuit unit 18, and a terminal unit 19. The terminal unit 19 includes a plurality of connection pads 19a to 19c. The protective circuit unit 18 is interposed between the connection pads 19a to 19c, and the internal circuit 17. The connection pads 19b and 19c are power input terminals (Vdd and Vss).

The protective circuit unit 18 includes a plurality of protective circuit elements 181 and 182 which are connected in series to each other. A signal wiring line 23 extending from the connection pad 19a is connected between the two protective circuit elements 181 and 182 with a resistive element 18b therebetween. On the other hand, a signal wiring line 24 extending from the internal circuit 17 is connected to the protective circuit elements 181 and 182 and the signal wiring line 23, with a resistive element 18c interposed between the signal wiring line 23 and the signal wiring line 24.

Further, the protective circuit element 181 has one end (the cathode side) connected to the connection pad 19b (Vdd) serving as the power input terminal through a signal wiring line, and the protective circuit element 182 has another end (the anode side) connected to the connection pad 19c (Vss) through a signal wiring line.

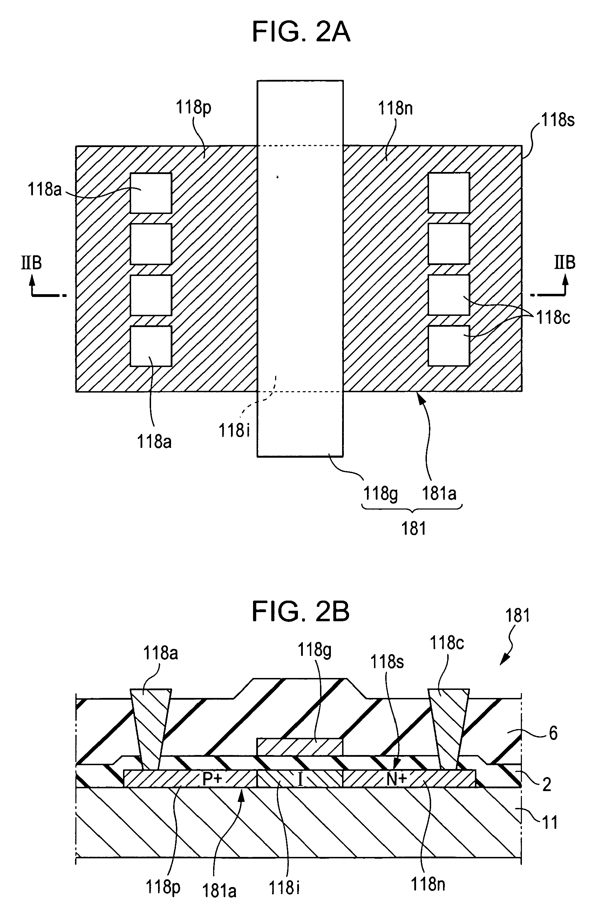

FIG. 2A is a plan view showing the detailed structure of the protective circuit element 181 shown in FIG. 1, and FIG. 2B is a cross-sectional view of the protective circuit element taken along the line II-II in FIG. 2A.

In addition, FIG. 2 shows only essential elements of the protective circuit element 181, except for wiring lines connected thereto, etc. Further, it should be noted that the protective circuit element 182 has the same structure as the protective circuit element 181.

Referring to FIG. 2, the protective circuit element 181 according to the present embodiment includes a PIN diode 181a, and a floating electrode 118g disposed to overlap a part of the PIN diode 181a. The PIN diode 181a includes a semiconductor film 118s, and a plurality (e.g., four in the drawing) of anode electrodes 118a and a plurality (e.g., four in the drawing) of cathode electrodes 118c connected to the semiconductor film 118s. The semiconductor film 118s includes a P layer 118p, an N layer 118n, and an I layer 118i disposed between the P layer 118p and the N layer 118n. The anode electrodes 118a are electrically connected to the P layer 118p. The cathode electrodes 118c are electrically connected to the N layer 118n. In addition, the floating electrode 118g is disposed in the I layer 118i of the PIN diode 181a in an opposite manner.

The cross-sectional structure of the protective circuit element will now be described with reference to FIG. 2B. The semiconductor film 118s formed of, for example, a polysilicon film, is formed on a substrate 11. A first insulating film 2 formed of, for example, silicon oxide, is formed to cover the semiconductor film 118s. The floating electrode 118g formed of, for example, aluminum, tantalum, molybdenum or polysilicon, is formed on the first insulating film 2. A second insulating film 6 is formed to cover the floating electrode 118g. Further, the anode electrode 118a and the cathode electrode 118c are buried in contact holes, which penetrate the second insulating film 6 and the first insulating film 2 to reach the semiconductor film 118s, and are then electrically connected to the P layer 118p and the N layer 118n, respectively.

The floating electrode 118g formed in the thin film semiconductor element 181 is composed of a conductive film that is buried between the first insulating film 2 and the second insulating film 6, as shown in FIG. 2B. The floating electrode 118g is an electrode that is not electrically connected to other elements, is not connected to a ground, and has the predetermined voltage.

Moreover, the internal circuit 17 shown in FIG. 1 includes a semiconductor element that is formed using a thin semiconductor film formed on the substrate 11, in the same manner as the protective circuit unit 18. The internal circuit 17 can include, for example, a TFT (thin film transistor).

In the thin film semiconductor device having the above-mentioned structure, the protective circuit unit 18 having the thin film semiconductor element 181 can effectively protect the internal circuit 17 from a positive surge voltage, such as static electricity, which is inputted through, e.g., the connection pad 19a. That is, if the surge voltage is inputted from the connection pad 19a, a current flows between the PIN diodes 181 and 182, whereby the surge current bypasses toward the power input terminal. It is thus possible to prevent an excessive current from flowing through the internal circuit 17.

Further, the thin film semiconductor device of the present embodiment has an advantage that cannot be obtained through the protective circuit according to the related art using the diode-connected TFT in that a problem does not occur in the electrical connection structure with the internal circuit 17 and the connection pad 19a even if the protective circuit elements 181 and 182 are broken due to the surge voltage exceeding the withstand voltage.

This will be described in detail by taking the protective circuit element 181 shown in FIG. 2 as an example. In a case in which the protective circuit element 181 having the floating electrode 118g is broken, the first insulating film 2 made of a thin insulating film is deteriorated due to the electrical charge in the same manner as a diode-connected TFT 30D shown in FIG. 9. This may make cause the P layer 118p (or the N layer 118n) of the PIN diode 181a and the floating electrode 118g to be short-circuited. Further, in such a shorted state, the diode-connected TFT 30D according to the related art becomes conductive. In the protective circuit element 181 according to the present embodiment, the P layer 118p and the floating electrode 118g are short-circuited, but the floating electrode 118g is not electrically connected to the other constituent elements. As a result, the anode electrode 118a and the cathode electrode 118c of the PIN diode 181a are not short-circuited. Therefore, after breakage, the protective circuit element 181 serves as a simple insulator. As such, since the circuit structure connecting the connection pad 19a and the internal circuit 17 remains intact, the circuit can normally operate without causing a problem in the thin film semiconductor device, even if the surge voltage exceeding the withstand voltage of the protective circuit is inputted.

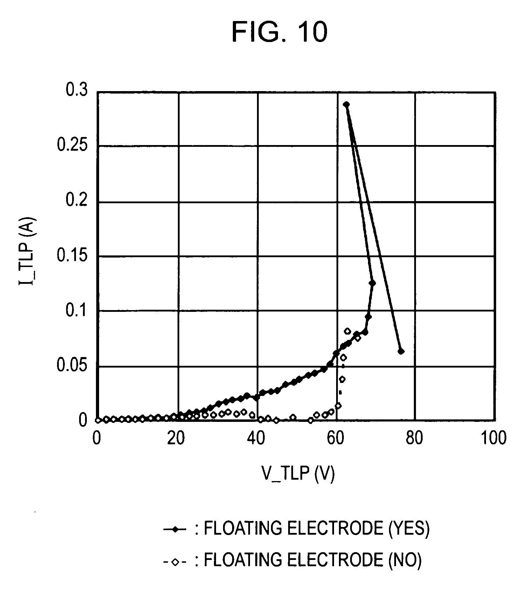

In addition, the protective circuit element according to the present embodiment is effective against a surge voltage in the reverse direction. FIG. 10 shows the results of measuring TLP (Transmission Line Pulse) characteristics of a PIN diode depending upon whether a floating electrode exists or not. In FIG. 10, the horizontal axis indicates the load voltage in the reverse direction applied to a protective circuit element, and the vertical axis indicates the current flowing through the protective circuit element in this case. In FIG. 10, the solid line corresponds to a case in which the floating electrode exists, and the broken line corresponds to a case in which the floating electrode does not exist. From FIG. 10, it can be seen that the graph showing the diode having the floating electrode has a gradient greater than that of the diode not having the floating electrode, in a region where the load voltage exceeds 20 V. Accordingly, the present embodiment is characterized in that the current flows even in a relatively low load voltage region even against a voltage in the reverse direction. Therefore, it is possible to form a protective circuit that can form a bypass for the low surge voltage in the reverse direction as well as the forward direction by using the protection element of the present embodiment. As such, the protective circuit element of the invention can have excellent protection performance as a protective element for both polarities.

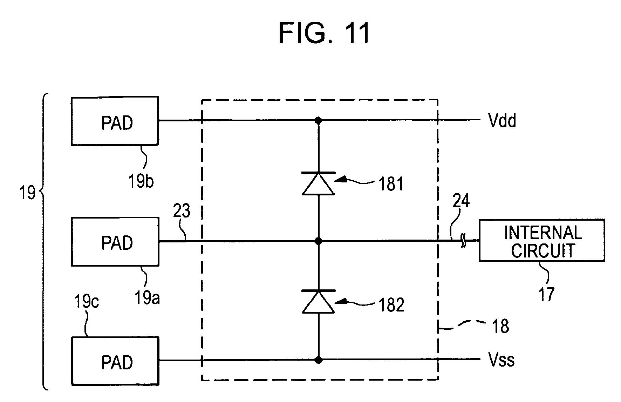

Furthermore, the thin film semiconductor device having the protective circuit unit 18 showing the above effect can have a structure in which the protective circuit elements 181 and 182, and the connection pad 19a are directly connected through the wiring line 23 without forming the resistive element 18b shown in FIG. 1, as shown in FIG. 11. The resistive element 18b serves to protect the circuit by suppressing a rapid rise of the voltage in the circuit when the surge voltage is inputted from the connection pad 19a. However, when an excessive surge voltage is inputted, the resistive element 18b can also be broken, which causing disconnection. If the resistive element 18b is disconnected, the connection pad 19a and the internal circuit 17 are disconnected, thus causing a problem in the operation of the thin film semiconductor device. On the other hand, if the protective circuit elements 181 and 182 are provided, but the resistive element 18b is not provided, the connection pad 19a and the internal circuit 17 can be still electrically connected to each other even when the protective circuit element is broken due to the excessive surge voltage. Therefore, since there is no possibility that the thin film semiconductor device itself may not operate due to the breakage of the protective circuit unit 18, the life span of the thin film semiconductor device can be improved.

### Electro-optical device

The thin film semiconductor device according to the above-mentioned embodiment can be constructed as an active-matrix-type electro-optical device. Hereinafter, an active-matrix-type transmissive liquid crystal display device will be described as an example of the electro-optical device having the thin film semiconductor device shown in FIG. 1.

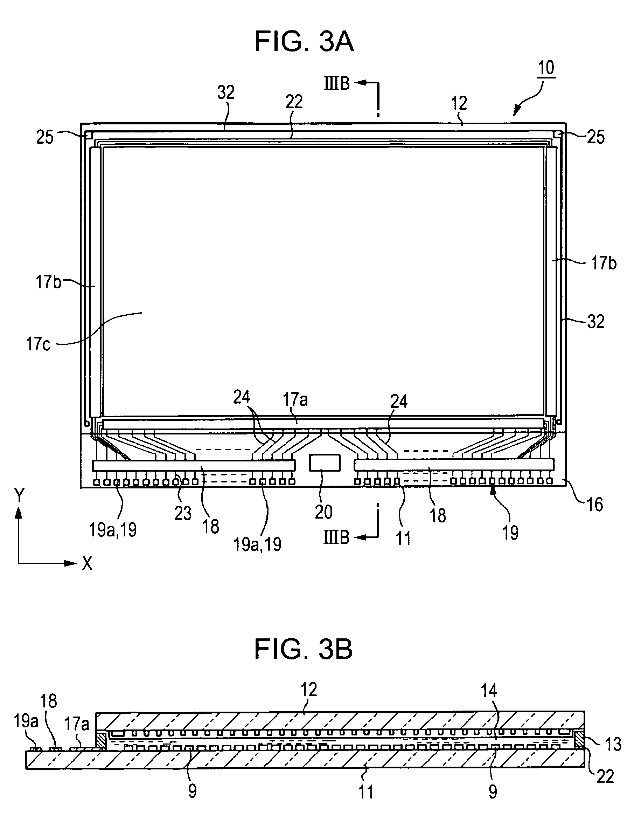

FIG. 3A is a plan view of the liquid crystal display device according to the present embodiment, which is viewed from the side of the counter substrate together with the respective constituent elements. FIG. 3B is a cross-sectional view of the liquid crystal display device taken along the line III-III in FIG. 3A. Further, in the drawings used for the following description, the scale of each layer or member is adjusted in order to have a recognizable size in the drawings.

The liquid crystal display device 10 according to the present embodiment has a structure in which a TFT array substrate 11 (a base substrate) and an counter substrate 12, each made of a transparent substrate, are bonded by sealants 13, and a liquid crystal layer 14 is sealed within a space defined by the sealant 13, as shown in FIGS. 3A and 3B. An image display area 17c is formed approximately at the center of the TFT array substrate 11. In a frame region 16 outside the image display area 17c, a data line driving circuit 17a is disposed at an area that extends along one side (a side extending in an X direction in FIG. 3) of the TFT array substrate 11. The data line driving circuit 17a is composed of unit circuits (not shown) in the same number as the number of pixels of the image display area 17c in the X direction. On the other hand, two scanning line driving circuits 17b are respectively formed at both sides of the image display area 17c along two short sides (sides extending in a Y direction in FIG. 3A) of the TFT array substrate 11. Further, a plurality of wiring lines 22, which connects the two scanning line driving circuits 17b and 17b disposed at both sides of the image display area 17c, are provided at the one remaining side of the TFT array substrate 11.

Further, a plurality of connection pads 19a for connecting an FPC (Flexible Printed Circuit) to the corresponding TFT array substrate 11 are disposed near one end of the data line driving circuit 17a of the TFT array substrate 11 at a predetermined pitch in the X direction. A protective circuit unit 18 is also disposed between the connection pads 19a and the data line driving circuit 17a. A plurality of wiring lines 23 and 24, which extends from the connection pads 19a, electrically connects the data line driving circuit 17a, and the two scanning line driving circuits 17b and 17b and the connection pad 19a via the protective circuit unit 18.

Therefore, in the liquid crystal display device 10 according to the present embodiment, the data line driving circuit 17a, the two scanning line driving circuits 17b, and the image display area 17c are constituent elements corresponding to the internal circuit (main circuit unit) 17 shown in FIG. 1. The internal circuit and a connection unit 19 including the plurality of connection pads 19a are electrically connected with the protective circuit unit 18 disposed therebetween.

Furthermore, the protective circuit unit 18 disposed between the data line driving circuit 17a and the connection pads 19a is an electrostatic protective circuit including the protective circuit elements 181 and 182 serving as main elements, as shown in FIGS. 1 and 2. The protective circuit unit 18 is adapted to protect the pixel switching elements formed within the image display area 17c or the driving circuits 17a and 17b by allowing the protective circuit elements 181 and 182 to bypass a surge current. In the present embodiment, two protective circuit units 18 are disposed for use.in the right side and the left side of the image display area 17c, respectively.

In addition, inter-substrate conductive members 25 (upper and lower conductive units) for electrical connection between the TFT array substrate 11 and the counter substrate 12 are disposed at the corners of the counter substrate 12. A common electrode (not shown) is disposed in the counter substrate 12. A wiring line 32 for supplying a common potential to the common electrode is disposed on the TFT array substrate 11 with the inter-substrate conductive members 25 interposed therebetween, and is disposed on the outermost side of the TFT array substrate 11. In FIG. 3B, a reference numeral 9 indicates a pixel electrode disposed for every pixel within the image display area 17c.

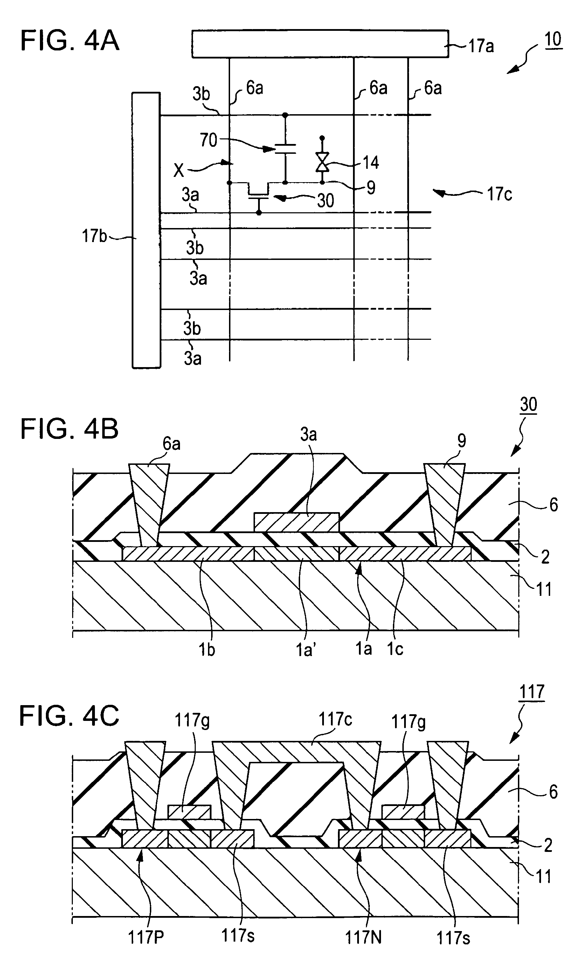

Next, FIG. 4A is a circuit diagram of the liquid crystal display device 10, and FIG. 4B is a cross-sectional view schematically showing the TFT 30 shown in FIG. 4A. As shown in FIG. 4A, a plurality of data lines 6a and a plurality of scanning lines 3a, which extend to cross each other, are formed in the image display area 17c of the liquid crystal display device 10. A pixel X is formed at a rectangular shaped area, which is defined by the data lines 6a and the scanning line 3a. It should be noted that although only one pixel X is shown in FIG. 4, a plurality of pixels X are arranged in the image display area 17c in a matrix in plan view.

In each pixel, a TFT 30 serving as a pixel switching element is disposed so as to correspond to a location where the data line 6a and the scanning line 3a intersect each other. The TFT 30 has a gate connected to the scanning line 3a, a source connected to the data lines 6a, and a drain connected to the pixel electrode 9, which applies an electric field to the liquid crystal layer 14. In addition, a storage capacitor 70 is connected in parallel to the pixel electrode 9, and an electrode opposite the pixel electrode 9 is connected to a capacitor line 3b.

The sectional structure of the TFT 30 will now be described with reference to FIG. 4B. A semiconductor film 1a is formed on a TFT array substrate 11. A gate insulating film (a first insulating film) 2 is formed to cover the semiconductor film 1a. A gate electrode (a scanning line) 3a is formed opposite to the semiconductor film 1a with the gate insulating film 2 disposed therebetween. The semiconductor film 1a includes a source region 1b, a drain region 1c, and a channel region 1a'. The channel region 1a' is disposed opposite to the gate electrodes 3a in the semiconductor film 1a. An interlayer insulating film (a second insulating film) 6 is formed to cover the gate electrodes 3a and the gate insulating film 2. Contact holes, which penetrate the interlayer insulating film 6 and the gate insulating film 2 and then reach the source region 1b and the drain region 1c of the semiconductor film 1a, are formed. The data lines 6a and the source region 1b, as well as the pixel electrode 9 and the drain region 1c, are electrically connected to each other through the contact holes. The TFT 30 may be a P channel type or an N channel type.

FIG. 4C is a schematic cross-sectional view of an inverter (CMOS-TFT) 117 provided in the data line driving circuit 17a and the scanning line driving circuit 17b. The inverter 117 has a structure in which a P channel TFT 117P and an N channel TFT 117N are connected to each other through an electrode (an output terminal) 117c. The TFTs 117P and 117N are formed by using semiconductor films 117s formed on the TFT array substrate 11. Gate electrodes (input terminals) 117g and the semiconductor films 117s are disposed opposite to each other with the gate insulating film 2, which is formed to cover the semiconductor films 117s, therebetween.

In the present embodiment, the semiconductor film 1a of the TFT 30 shown in FIG. 4B, the semiconductor films 117s of the inverter 117 shown in FIG. 4C, and the semiconductor film 118s of the protective circuit element 181 shown in FIG. 2B are all formed by using a semiconductor film formed in the same layer on the TFT array substrate 11. Further, the gate electrodes 3a of the TFT 30, the gate electrodes 117g of the inverter 117, and the floating electrode 118g of the protective circuit element 181 are all formed by a conductive film formed on the gate insulating film (the first insulating film) 2, which is formed to cover the semiconductor film. Further, in any semiconductor element, an intrinsic semiconductor area or the channel region 1a' serving as a region into which an impurity of a low concentration is implanted, the I layer 118i, and so on are disposed in the region in which the semiconductor film and the gate electrode (or the floating electrode) overlap each other in plan view.

The liquid crystal display device 10 according to the present embodiment constructed above has the structure of the above-mentioned thin film semiconductor device. Therefore, it can protect internal circuits (the data line driving circuit 17a, the scanning line driving circuit 17b, and the image display area 17c) from the surge voltage inputted through the connection pad 19a by using the protective circuit unit 18. This leads to liquid crystal display devices with excellent reliability and a long life span, in which the internal circuits are seldom broken during manufacture or use. Further, even in a case in which the surge voltage exceeding the withstand voltage of a PIN diode constituting the protective circuit unit 18 is inputted and the PIN diode is broken, the protective circuit unit 18 has an advantage in that the connection pads 19a are not short-circuited. Therefore, there is an advantage in that failure dose not occur in the operation of the liquid crystal display device.

Further, as described above, the semiconductor elements (the TFT 30, the inverter 117 and the protective circuit element 181) that are provided in the liquid crystal display device 10 have a common structure in which the conducting layers are disposed opposite to the semiconductor film with the insulating film interposed therebetween. As a result, the formation process of the semiconductor films 1a, 117s and 118s, and the formation process of the gate electrodes 3a and 117g, and the floating electrode 118g can be a common formation process. In addition, even in the case where the impurity is introduced into the semiconductor film, the channel region of the transistor and the I layer of the PIN diode can be formed in a self-aligned manner by introducing the impurity into the semiconductor film using the gate electrodes 3a and 117g and the floating electrode 118g as masks.

Therefore, in the liquid crystal display device 10 according to the present embodiment, the protective circuit unit 18 serving as the electrostatic protective circuit of the data line driving circuit 17a, the scanning line driving circuit 17b and the image display area 17c, which constitute the internal circuits, can be formed by means of a process of forming the internal circuit at the same time. This does not make a manufacturing process complicated, and can improve the reliability of liquid crystal display devices.

### Second Embodiment

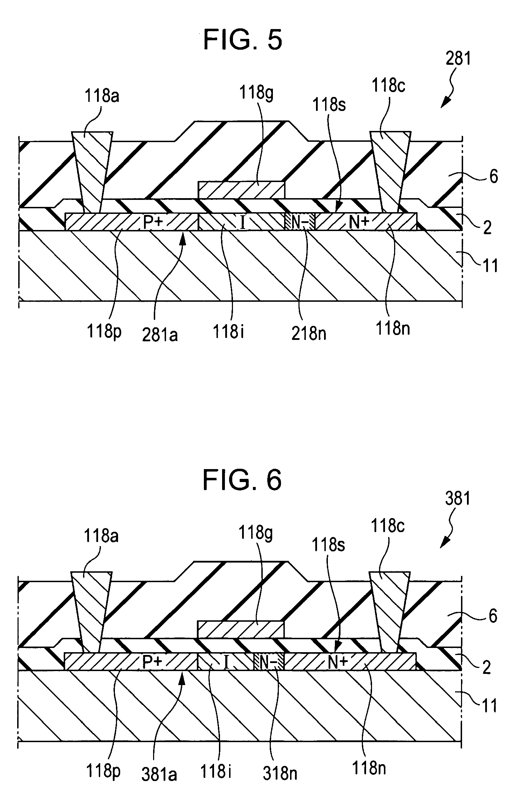

A second embodiment of the invention will now be described. FIG. 5 is a cross-sectional view schematically showing a protective circuit element provided in a thin film semiconductor device according to a second embodiment of the invention. FIG. 5 corresponds to FIG. 2B illustrating the first embodiment. The planar structure of a protective circuit element 281 according to the second embodiment is almost the same as that of the protective circuit element 181 shown in FIG. 2A.

The protective circuit element 281 shown in FIG. 5 includes a PIN diode 281a and a floating electrode 118g serving as main elements. In addition, between the N layer 118n and an I layer 118i disposed at a location where a semiconductor film 118s of the PIN diode 281a and the floating electrode 118g overlap each other in plan view, formed is a low concentration impurity region 218n serving as a region whose impurity concentration is lower than that of an N layer 118n.

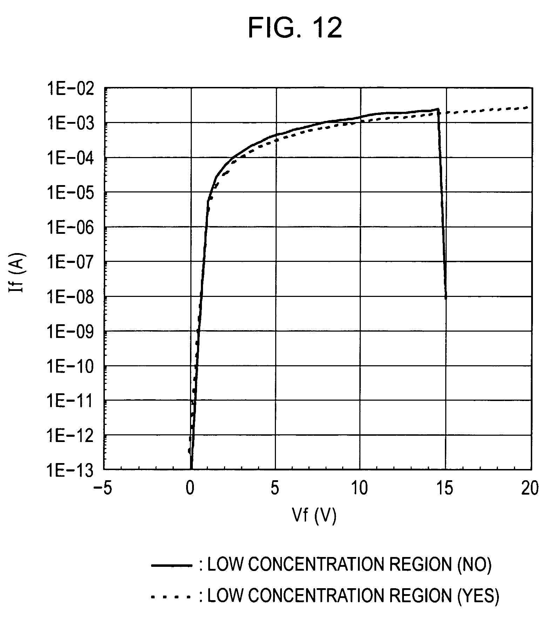

FIG. 12 is a graph showing the results of comparing voltage-current characteristics between the protective circuit element according to the present embodiment and the protective circuit element according to the first embodiment. In FIG. 12, a horizontal axis indicates the application voltage, and a vertical axis indicates the current. Further, a solid line indicates : characteristics of the element according to the first embodiment, which does not have the low concentration region between the I layer and the N layer, and a broken line indicates characteristics of a protection element according to the second embodiment, which has the low concentration region between the I layer and the N layer. From FIG. 12, it can be clearly seen that the broken line exceeds 15 V, and the withstand voltage of the protective circuit element according to the present embodiment increases. As such, if the low concentration impurity region is formed in each of the I layer and the N layer of the PIN diode or between the I layer and the P layer, the withstand voltage of the protective circuit element can increase and the withstand voltage of the protective circuit can also increase, which the reliability is further improved.

In a TFT used in the pixel switching element or the driving circuit, however, in order to suppress variations of electrical characteristics (threshold value Vₜₕ, transfer conductance gm, drain current I_{ds}, etc.) due to hot carriers implanted into the gate insulating film, the LDD (Lightly Doped Drain) structure in which a high resistance layer is formed near the drain, is adopted to mitigate an electric field in the channel boundary. Therefore, by forming the low concentration impurity region (high resistance area) 218n between the I layer 118i and the N layer 118n, as in the PIN diode 218a according to the present embodiment, the TFT can be easily formed in the same process as the TFT of the internal circuits, in the same manner as the protective circuit element 181 according to the first embodiment.

### Third Embodiment

Next, a third embodiment of the invention will be described. FIG. 6 is a cross-sectional view schematically showing a protective circuit element provided in a thin film semiconductor device according to a third embodiment of the invention. FIG. 6 corresponds to FIG. 2B illustrating the first embodiment. The planar structure of a protective circuit element 381 according to the present embodiment is the same as that of the protective circuit element 181 shown in FIG. 2A.

The protective circuit element 381 shown in FIG. 6 includes a PIN diode 381a and a floating electrode 118g as main elements. The PIN diode 381a is the same as the PIN diode 281a shown in FIG. 5 in that between an N layer 118n and an I layer 118i disposed at a location where a semiconductor film 118s of the PIN diode 381a and the floating electrode 118g overlap each other in plan view, formed is a low concentration impurity region 318n serving as a region whose impurity concentration is lower than that of an N layer 118n. In the PIN diode 381a according to the present embodiment, however, the low concentration impurity region 318n is formed at a location where it overlaps the floating electrode 118g in plan view.

The structure of the protective circuit element 381 is similar to that of a TFT having a so-called GOLDD (Gate Overlapped Lightly Dopped Drain) structure. Thus, in a case where a TFT constituting an internal circuit has the GOLDD structure, if the PIN diode 381a constituting the protective circuit element has the structure in which the low concentration impurity region 318n is disposed to overlap the floating electrode in plan view, as in the present embodiment, the protective circuit element can be easily formed in the same process as the internal circuits, and a PIN diode having the high withstand voltage can also be formed in the same manner as the second embodiment.

Further, in a case where the TFT having the GOLDD structure is formed, while a gate electrode is formed using a metal film of the two-layer structure, the upper side metal film (a side opposite to a semiconductor film) of the corresponding gate electrode is formed to have an area narrower than that of the lower metal film thereof. In this state, an impurity is introduced into the semiconductor film by using the gate electrode as a mask. In this way, a low concentration impurity region can be formed in the semiconductor film in a self-aligned manner so as to correspond to the region where the lower metal film is larger than the upper metal film.

Therefore, even in the case where the protective circuit element 381 according to the present embodiment is fabricated, the floating electrode 118g is formed to have the two-layer structure in the same manner as the gate electrode of the TFT having the GOLDD structure, and an impurity is implanted into the N layer 118n. The low concentration impurity region 318n can be thus formed within the planar region of the floating electrode 118g.

### Fourth Embodiment

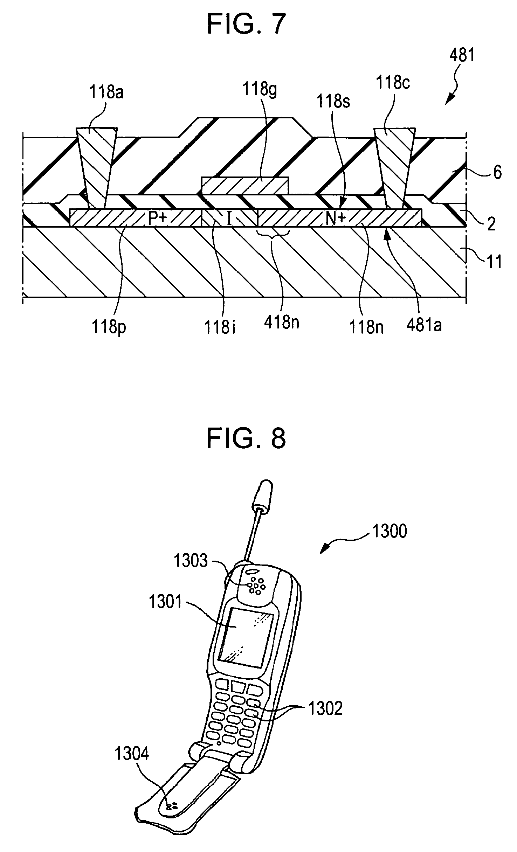

A fourth embodiment of the invention will now be described. FIG. 7 is a cross-sectional view schematically showing a protective circuit element provided in a thin film semiconductor device according to a fourth embodiment of the invention. FIG. 7 corresponds to FIG. 2B illustrating the first embodiment. The planar structure of a protective circuit element 481 according to the present embodiment is the same as that of the protective circuit element 181 shown in FIG. 2A.

The protective circuit element 481 shown in FIG. 7 includes a PIN diode 481a and a floating electrode 118g serving as main elements. The present embodiment is the same as the above-mentioned first to third embodiments in that the I layer 118i is disposed at a location where the semiconductor film 118s of the PIN diode 481a and the floating electrode 118g overlap each other in plan view, but is different from the first to third embodiments in that the N layer 118n extends to a region where the floating electrode 118g and the semiconductor film 118s overlap each other in plan view. Even though the PIN diode 481a having this extending portion 418n of the N layer is used, the same effects as those of the above-mentioned embodiments can be obtained. Further, although the low concentration impurity regions 218n and 318n are provided between the P layer 118p and the I layer 118i and between the N layer 118n and I layer 118i and the floating electrode 118g extends up to over the P layer 118p or the N layer 118n of the PIN diode shown in the second and third embodiments, a protective circuit element having the same high withstand voltage and a protection function against the surge voltage of a backward direction can be provided.

In the above-mentioned first to third embodiments, a case in which the impurity is introduced into the semiconductor film 118s using the floating electrode 118g, which is disposed to partially overlap the semiconductor film 118s in plan view, as a mask, has been described. In the process of forming the TFT constituting the internal circuit, it is not necessarily required to use the method of forming the channel region in a self-aligned manner. For example, an impurity can be introduced into a semiconductor film by using a photoresist formed on a gate insulating film as a mask. In this case, after the impurity is introduced, a gate electrode is formed. It is thus possible to adopt even the structure in which the gate electrode and the impurity-introduced region (e.g., a drain region) are disposed to partially overlap each other in plan view. Therefore, if the TFT having the structure is formed as the internal circuit, it is effective to use a protective circuit element having the PIN diode 481a according to the present embodiment in terms of the standardization of the manufacturing process.

### Electronic apparatus

Exemplary embodiments of electronic apparatuses having the liquid crystal display device according to the above-described embodiments of the invention will now be described.

FIG. 8 is a perspective view illustrating an example of a cellular phone. In FIG. 8, a reference numeral 1300 indicates a cellular phone body, and a reference numeral 1301 indicates a display unit using the liquid crystal display device. A reference numeral 1302 indicates an operating portion, and reference numerals 1303 and 1304 indicate an earpiece and a mouthpiece, respectively.

The electronic apparatus shown in FIG. 8 has the display unit using the liquid crystal display device according to the above-described embodiments. It is thus possible to realize an electronic apparatus having the liquid crystal display unit with high reliability and a long life span.

While the invention has been described with reference to the particular illustrative embodiments, it is not limited to the embodiments but only by the appended claims. It is to be appreciated that those skilled in the art can change or modify the embodiments without departing from the scope and spirit of the invention. For example, the invention can be applied to electro-optical devices using an active matrix substrate, and can also be applied to light-emitting devices of a current driving type, such as organic EL displays, as well as liquid crystal display devices. Further, the arrangement of peripheral circuits, such as a data line driving circuit and a scanning line driving circuit, is not limited to the above-mentioned embodiments, but can be arbitrarily modified.

## Claims

1. A thin film semiconductor device comprising:
a substrate;
a semiconductor film formed on the substrate; and
a protective circuit element that includes a PIN diode having the semiconductor film, and a floating electrode disposed opposite to an I layer of the PIN diode with an insulating film interposed therebetween.

2. A thin film semiconductor device comprising:
a main circuit unit having a semiconductor element;
a terminal unit extending from the main circuit unit; and
a protective circuit unit disposed between the main circuit unit and the terminal unit,
wherein all of the main circuit, the terminal unit, and the protective circuit are formed on a substrate, and
the protective circuit unit includes a protective circuit element that includes a PIN diode having the semiconductor film, and a floating electrode disposed opposite to an I layer of the PIN diode with an insulating film interposed therebetween.

3. The thin film semiconductor device according to Claim 2,
wherein the semiconductor film constituting the PIN diode and a semiconductor film constituting the semiconductor element of the main circuit unit is are formed in the same layer on the substrate.

4. The thin film semiconductor device according to Claim 2,
wherein the semiconductor element provided in the main circuit unit is a thin film transistor, and
a conductive film constituting the floating electrode and a conductive film constituting a gate electrode of the thin film transistor are formed in the same layer on the substrate.

5. The thin film semiconductor device according to Claim 1,
wherein the floating electrode and the I layer of the PIN diode are formed approximately at the same location in plan view.

6. The thin film semiconductor device according to Claim 1,
wherein the PIN diode has a low concentration impurity region, which has an impurity concentration lower than that of a P layer or a N layer, between the P layer and the I layer or between the N layer and the I layer.

7. The thin film semiconductor device according to Claim 6,
wherein the low concentration impurity region is formed in a region where the low concentration impurity region overlaps the floating electrode in plan view.

8. The thin film semiconductor device according to Claim 1,
wherein the floating electrode disposed opposite to the I layer of the PIN diode with the insulating film interposed therebetween has a portion where the floating electrode overlaps some of the P layer or the N layer of the PIN diode.

9. The thin film semiconductor device according to Claim 2,
wherein the protective circuit element is directly connected to the terminal unit.

10. A method of manufacturing a thin film semiconductor device having a substrate and a semiconductor film formed on the substrate, the method comprising:
forming a protective circuit element,
wherein the forming of the protective circuit element includes:
forming an insulating film on the semiconductor film formed on the substrate;
forming a conductive film on the insulating film to form a floating electrode overlapping the semiconductor film in plan view; and
forming a P layer, an N layer, and an I layer in the semiconductor film by introducing an impurity into the semiconductor film using the floating electrode as a mask to form a PIN diode.

11. A method of manufacturing a thin film semiconductor device including a main circuit unit having a semiconductor element, a terminal unit extending from the main circuit unit, and a protective circuit unit disposed between the main circuit unit and the terminal unit, all of which are formed on a substrate, the method comprising:
forming the protective circuit unit which includes forming of a protective circuit element,
wherein the forming of the protective circuit element includes:
forming an insulating film on the semiconductor film formed on the substrate;
forming a conductive film on the insulating film to form a floating electrode overlapping the semiconductor film in plan view; and
forming a P layer, an N layer, and an I layer in the semiconductor film by introducing an impurity into the semiconductor film using the floating electrode as a mask to form a PIN diode.

12. The method of manufacturing a thin film semiconductor device according to Claim 11,
wherein the main circuit unit includes a TFT having a semiconductor film and a gate electrode opposite to the semiconductor film with an insulating film interposed therebetween,
the semiconductor film constituting the TFT and a semiconductor film constituting the protective circuit element are formed in the same process, and
the gate electrode constituting the TFT and the floating electrode constituting the protective circuit element are formed in the same process.

13. The method of manufacturing a thin film semiconductor device according to Claim 12,
wherein a source or drain of the TFT, and the P layer or the N layer of the PIN diode are formed in the same impurity introducing process.

14. The method of manufacturing a thin film semiconductor device according to Claim 11,
wherein in the impurity introducing process, a low concentration impurity region having a lower impurity concentration than that of a neighboring impurity introduction region is formed in the semiconductor film of the TFT and the semiconductor film of the protective circuit element.

15. An electro-optical device comprising the thin film semiconductor device according to Claim 1.

16. An electronic apparatus comprising the electro-optical device according to Claim 15.
